# EUROPÄISCHE PATENTSCHRIFT

(11) **EP 1 221 724 B1**
(45) Veröffentlichungstag und Bekanntmachung des Hinweises auf die Patenterteilung: **16.02.2011**
(21) Anmeldenummer: 02007512.3
(22) Anmeldetag: 22.09.1997
(51) Int. Cl.: H01L 33/00

(54) **Wellenlängenkonvertierende Vergussmasse, deren Verwendung und Verfahren zu deren Herstellung**
Sealing material with wavelength converting effect, application and production process
Masse de scellement à effet convertisseur de longueur d'onde, utilisation et procédé de production

(30) Priorität: 20.09.1996 DE 19638667
(43) Veröffentlichungstag der Anmeldung: 10.07.2002
(62) Teilanmeldung aus: 97909167.5
(73) Patentinhaber: OSRAM Opto Semiconductors GmbH, 93055 Regensburg (DE)
(72) Erfinder: Debray, Alexandra, 90491 Nürnberg (DE); Höhn, Klaus, 82024 Taufkirchen (DE); Schlotter, Peter, 79112 Freiburg (DE); Schmidt, Ralf, 79279 Voerstetten (DE); Schneider, Jürgen, 99117 Freiburg (DE)
(74) Vertreter: Epping - Hermann - Fischer

(56) Entgegenhaltungen:
- WO-A-96/23030
- WO-A1-98/05078
- US-A- 4 479 886
- SCHREIBEN VON HERR WUSTLICH/WUSTLICH MICRO/OPTO-ELEKTRONIK GMBH AN HERR MENDEN/MENDEN BUCHSTABEN, 22. September 1995 (1995-09-22), XP002324886
- "White-LED lamp, efficient light emission, half a production cost" ZEITUNGSARTIKEL NIKKEI SANGYO SHIMBUN, 13. September 1996 (1996-09-13), XP002324888
- PATENT ABSTRACTS OF JAPAN Bd. 017, Nr. 542 (E-1441), 29. September 1993 (1993-09-29) & JP 05 152609 A (NICHIA CHEM IND LTD), 18. Juni 1993 (1993-06-18)

## Beschreibung

Die Erfindung betrifft eine wellenlängenkonvertierende vergußmasse auf der Basis eines transparenten Epoxidgießharzes, das mit einem Leuchtstoff versetzt ist, insbesondere für die Verwendung bei einem elektrolumineszierenden Bauelement mit einem ultraviolettes, blaues oder grünes Licht aussendenden Körper.

In der früher eingereichten, aber nach dem Anmeldetag dieser Anmeldung veröffentlichten internationalen Anmeldung WO-A-98/05078 (EP-A-936 682) mit Bestimmung EP, die Stand der Technik gemäß Artikel 54 (3) und (4) EPÜ darstellt, ist ein Leuchtdiodenbauelement beschrieben, bei dem ein Leuchtdiodenchip mit einem Emissionsspektrum im ultravioletten, blauen und grünen Spektralbereich in einer transparenten Vergußmasse eingebettet ist, die anorganische Leuchtstoffpigmente auf der Basis von Cer-dotiertem Yttrium-Aluminium-Granat (Y₃Al₅O₁₂:Ce) enthält.

Aus der Offenlegungsschrift DE 38 04 293 ist eine Anordnung mit einer Elektrolumineszenz- oder Laserdiode bekannt, bei der das von der Diode abgestrahlte Emmissionsspektrum mittels eines mit einem fluoreszierenden, lichtwandelnden organischen Farbstoff versetzten Elements aus Kunststoff zu größeren Wellenlängen hin verschoben wird. Das von der Anordnung abgestrahlte Licht weist dadurch eine andere Farbe auf als das von der Leuchtdiode ausgesandte. Abhängig von der Art des dem Kunststoff beigefügten Farbstoffes lassen sich mit ein und demselben Leuchtdiodentyp Leuchtdiodenanordnungen herstellen, die in unterschiedlichen Farben leuchten.

In vielen potentiellen Anwendungsgebieten für Leuchtdioden, wie zum Beispiel bei Anzeigeelementen im Kfz-Armaturenbereich, Beleuchtung in Flugzeugen und Autos und bei vollfarbtauglichen LED-Displays, tritt verstärkt die Forderung nach Leuchtdiodenanordnungen auf, mit denen sich mischfarbiges Licht, insbesondere weißes Licht erzeugen läßt.

Die bislang bekannten Vergußmassen der eingangs genannten Art mit organischen Leuchtstoffen zeigen bei Temperatur- und Temperatur-Feuchtebeanspruchung jedoch eine Verschiebung des Farbortes, also des Farbe des vom elektrolumineszierenden Bauelement abgestrahlten Lichtes.

In JP-07 176 794-A ist eine weißes Licht aussendende planare Lichtquelle beschrieben, bei der an einer Stirnseite einer transparenten Platte zwei blaues Licht emittierende Dioden angeordnet sind, die Licht in die transparente Platte hinein aussenden. Die transparente Platte ist auf einer der beiden einander gegenüberliegenden Hauptflächen mit einer fluoreszierenden Substanz beschichtet, die Licht emittiert, wenn sie mit dem blauen Licht der Dioden angeregt wird. Das von der fluoreszierenden Substanz emittierte Licht hat eine andere Wellenlänge als das von den Dioden emittierte blaue Licht. Bei diesem bekannten Bauelement ist es besonders schwierig, die fluoreszierende Substanz in einer Art und Weise aufzubringen, daß die Lichtquelle homogenes weißes Licht abstrahlt. Darüber hinaus bereitet auch die Reproduzierbarkeit in der Massenfertigung große Probleme, weil schon geringe Schichtdickenschwankungen der fluoreszierenden Schicht, z. B. aufgrund von Unebenheiten der Oberfläche der transparenten Platte, eine Änderung des weißtones des abgestrahlten Lichtes hervorruft.

In der WO-A-96/23030 ist ein Weg angegeben, um Anzeigeelmente in Automobilen, wie sie beispielsweise in Armaturenbrettern vorhanden sind, nachts sichtbar zu machen. Dazu werden die Anzeigeelemente mit einer fluoreszierenden Tinte versehen, die mittels einer entsprechend angeordneten UV-Strahlungsquelle von der Vorderseite der Anzeigeelemente her mit UV-Strahlung beaufschlagt wird. Die fluoreszierende Tinte umfasst Acrylharz und eine Mischung aus mit sichtbarem Licht aktivierten Pigmenten und langwellig UV-aktivierten, mit Seltenen Erden dotierten, anorganischen Leuchtstoffpigmenten. Die Korngrößen der Pigmente werden unter 15 µm gehalten, um die Tinte siebdruckbar zu machen.

Der vorliegenden Erfindung liegt die Aufgabe zugrunde, eine Vergußmasse der eingangs genannten Art zu entwickeln, mit der elektrolumineszierende Bauelemente hergestellt werden können, die homogenes mischfarbiges Licht abstrahlen und die eine Massenfertigung mit vertretbarem technischen Aufwand und mit weitestgehend reproduzierbarer Bauelementcharakteristik ermöglicht. Das abgestrahlte Licht soll auch bei Temperatur- und Temperatur-Feuchtebeanspruchung farbstabil sein. Desweiteren soll ein Verfahren zum Herstellen dieser Vergußmasse angegeben werden.

Diese Aufgabe wird durch eine Vergußmasse mit den Merkmalen des Anspruches 1 gelöst. Vorteilhafte Weiterbildungen der Vergußmasse sind in den Ansprüchen 2 bis 6 angegeben. Ein Verfahren zur Herstellung der Vergußmasse sowie vorteilhafte Weiterbildungen davon sind in den Ansprüchen 7 bis 14 angegeben. Verfahren zur Herstellung eines lichtabstrahlenden Halbleiterbauelements mit der Vergußmasse sind in den Ansprüchen 15 und 16 angegeben. Ein lichtabstrahlendes Halbleiterbauelement mit der Vergußmasse und vorteilhafte Weiterbildungen davon sind in den Ansprüchen 17 bis 35 angegeben. Schließlich sind in den Ansprüchen 36 und 37 Halbleiterkörper mit der Vergußmasse angegeben. Besonders bevorzugt liegt der mittlere Korndurchmesser d₅₀ zwischen 1 und 2 µm. Bei diesen Korngrößen können günstige Fertigungsausbeuten erhalten werden,

Anorganisch-mineralische Leuchtstoffe sind vorteilhafterweise äußerst temperatur- und temperatur-feuchtestabil.

Bei einer besonders bevorzugten weiterbildung der erfindungsgemäßen Vergußmasse setzt sich diese zusammen aus:
a) Epoxidgießharz ≥ 60 Gew%
b) Leuchtstoffpigmente ≤ 25 Gew%
c) Thixotropiermittel ≤ 10 Gew%
d) mineralischem Diffusor ≤ 10 Gew%
e) Verarbeitungshilfsmittel ≤ 3 Gew%
f) Hydrophobiermittel ≤ 3 Gew%
g) Haftvermittler ≤ 2 Gew%.

Geeignete Epoxidgießharze sind beispielsweise in der DE-OS 26 42 465 auf den Seiten 4 bis 9, insbesondere Beispiele 1 bis 4, und in der EP 0 039 017 auf den Seiten 2 bis 5, insbesondere Beispiele 1 bis 8, beschrieben, deren Offenbarungsgehalt hiermit durch Rückbezug aufgenommen wird.

Als Thixotropiermittel ist beispielsweise pyrogene Kieselsäure verwendet. Das Thixotropiermittel dient zur Eindickung des Epoxidgießharzes, um die Sedimentation des Leuchtpigmentpulvers zu vermindern. Für die Gießharzverarbeitung werden weiter die Fließ- und Benetzungseigenschaften eingestellt.

Als mineralischer Diffusor zur Optimierung des Leuchtbildes des Bauelements ist bevorzugt CaF₂ verwendet.

Als Verarbeitungshilfsmittel eignet sich beispielsweise Glykolether. Es verbessert die Verträglichkeit zwischen Epoxidgießßharz und Leuchtpigmentpulver und dient damit zur Stabilisierung der Dispersion Leuchtpigmentpulver - Epoxidgießharz. Zu diesem Zweck können auch Oberflächenmodifikatoren auf Silikonbasis eingesetzt werden.

Das Hydrophobiermittel, z. B. flüssiges Silikonwachs, dient ebenfalls zur Modifikation der Pigmentoberfläche, insbesondere wird die Verträglichkeit und Benetzbarkeit der anorganischen Pigmentoberfläche mit dem organischen Harz verbessert.

Der Haftvermittler, z. B. funktionelles Alkoxysiloxan, verbessert die Haftung zwischen den Pigmenten und dem Epoxidharz im ausgehärteten Zustand der Vergußmasse. Dadurch wird erreicht, daß die Grenzfläche zwischen dem Epoxidharz und den Pigmenten z. B. bei Temperaturschwankungen nicht abreißt. Spalte zwischen dem Epoxidharz und den Pigmenten würden zu Lichtverlusten im Bauelement führen.

Das Epoxidgießharz, bevorzugt mit einem reaktiven Oxirandreiring, enthält vorzugsweise ein mono- und/oder ein mehrfunktionelles Epoxidgießharzsystem (≥ 80 Gew%; z. B. Bisphenol-A-Diglycidylether), einen Reaktivverdünner (≤ 10 Gew%; z. B. aromatischer Monoglycidylether), einen mehrfunktionellen Alkohol (≤ 5 Gew%), ein Entgasungsagens auf Silikonbasis (≤ 1 Gew%) und eine Entfärbungskomponente zur Einstellung der Farbzahl (≤ 1 Gew%).

Bei einer besonders bevorzugten Weiterbildung des Vergusses sind die Leuchtstoffpigmente kugelförmig oder schuppenförmig. Die Neigung zur Agglomeratbildung derartiger Pigmente ist vorteilhafterweise sehr gering. Der H₂O-Gehalt liegt unter 2%.

Bei der Herstellung und Verarbeitung von Epoxidgießharzkomponenten mit anorganischen Leuchtstoffpigmentpulvern treten im allgemeinen neben Benetzungs- auch Sedimentationsprobleme auf. Besonders Leuchtstoffpigmentpulver mit d₅₀ ≤ 5µm neigen stark zur Agglomeratbildung. Bei der zuletzt genannten Zusammensetzung der Vergußmasse können die Leuchtstoffpigmente vorteilhafterweise in der oben angegebenen Korngröße im Wesentlichen agglomeratfrei und homogen in das Epoxidgießharz dispergiert werden. Diese Dispersion ist auch bei längerer Lagerung der Vergußmasse stabil. Es treten im Wesentlichen keine Benetzungsund/oder Sedimentationsprobleme auf.

Besonders bevorzugt sind als Leuchtstoffpigmente Partikel aus der Gruppe der Ce-dotierten Granate, insbesondere YAG:Ce-Partikel verwendet. Eine vorteilhafte Dotierstoffkonzentration ist beispielsweise 1% und eine vorteilhafte Leuchtstoffkonzentration beträgt beispielsweise 12%. Desweiteren weist das bevorzugt hochreine Leuchtstoffpigmentpulver vorteilhafterweise einen Eisengehalt von ≤ 5ppm auf. Ein hoher Eisengehalt führt zu hohen Lichtverlusten im Bauelement. Das Leutstoffpigmentpulver ist stark abrasiv. Der Fe-Gehalt der Vergußmasse kann bei deren Herstellung daher beträchtlich ansteigen. Vorteilhaft sind Fe-Gehalte in der Vergußmasse < 20ppm.

Der anorganische Leuchtstoff YAG:Ce hat unter anderem den besonderen Vorteil, daß es sich hierbei um nicht lösliche Farbpigmente mit einem Brechungsindex von ca. 1,84 handelt. Dadurch treten neben der Wellenlängenkonversion Dispersion und Streueffekte auf, die zu einer guten Vermischung von blauer Diodenstrahlung und gelber Konverterstrahlung führen.

Besonders vorteilhaft ist weiterhin, dass die Leuchtstoffkonzentration im Epoxidharz bei Verwendung von anorganischen Leuchtstoffpigmenten nicht, wie bei organischen Farbstoffen, durch die Löslichkeit begrenzt wird.

Zur weiteren Verminderung der Agglomeratbildung können die Leuchtstoffpigmente vorteilhafterweise mit einem Silikon-Coating versehen sein.

Bei einem bevorzugten Verfahren zum Herstellen einer erfindungsgemäßßen Vergußmasse wird das Leuchtstoffpigmentpulver vor dem Vermischen mit dem Epoxidgießharz z. B. ca. 10 Stunden bei einer Temperatur ≥ 200°C getempert. Dadurch kann ebenfalls die Neigung zu Agglomeratbildung verringert werden.

Alternativ oder zusätzlich kann dazu das Leuchtstoffpigmentpulver vor dem Vermischen mit dem Epoxidgießharz in einem höher siedenden Alkohol geschlämmt und anschließend getrocknet wird. Eine weitere Möglichkeit die Agglomeratbildung zu verringern besteht darin, dem Leuchtstoffpigmentpulver vor dem Vermischen mit dem Epoxidgießharz ein hydrophobierendes Silikonwachs zuzugeben. Besonders vorteilhaft ist die Oberflächenstabilisierung der Phosphore durch erwärmen der Pigmente in Gegenwart von Glykolethern, z. B. 16 h bei T > 60°C.

Zur Vermeidung störender verunreinigungen beim Dispergieren der Leuchstoffpigmente, verursacht durch Abrieb, werden Reaktionsgefäße, Rühr- und Dispergiervorrichtungen sowie Walzwerke aus Glas, Korund, Carbid- und Nitridwerkstoffen sowie speziell gehärtete Stahlsorten verwendet. Agglomeratfreie Leuchtstoffdispersionen werden auch in Ultraschallverfahren oder durch den Einsatz von Sieben und Glaskeramikfritten erhalten.

Ein besonders bevorzugter anorganischer Leuchtstoff zur Herstellung von Weiß leuchtenden optoelektronischen Bauelementen ist der Phosphor YAG: Ce (Y₃Al₅O₁₂:Ce³⁺). Dieser läßt sich auf besonders einfache Weise in herkömmlich in der LED-Technik verwendeten transparenten Epoxidgießharzen mischen. Weiterhin als Leuchtstoffe denkbar sind weitere mit Seltenen Erden dotierte Granate wie z. B. Y₃Ga₅O₁₂:Ce³⁺, Y₃(Al, Ga)₅O₁₂:Ce³⁺ und Y₃(Al, Ga)₅O₁₂:Tb³⁺.

Zur Erzeugung von mischfarbigem Licht eignen sich darüberhinaus besonders die mit Seltenen Erden dotierten Thiogallate wie z. B. CaGa₂S₄:Ce³⁺ und SrGa₂S₄:Ce³⁺. Ebenso ist hierzu die Verwendung von mit Seltenen Erden dotierten Aluminaten wie z. B. YA-lO₃:Ce³⁺, YGaO₃:Ce³⁺, Y(Al,Ga)O₃:Ce³⁺ und mit Seltenen Erden dotierten Orthosilikaten M₂SiO₅:Ce³⁺ (M: Sc, Y, Sc) wie z. B. Y₂SiO₅:Ce³⁺ denkbar. Bei allen Yttriumverbindungen kann das Yttrium im Prinzip auch durch Scandium oder Lanthan ersetzt werden.

Bevorzugt wird die erfindungsgemäße Vergußmasse bei einem strahlungsemittierenden Halbleiterkörper, insbesondere mit einer aktiven Halbleiterschicht oder -schichtenfolge aus GaₓIn₁₋ₓN oder GaₓAl₁₋ₓN, eingesetzt, der im Betrieb eine elektromagnetische Strahlung aus dem ultravioletten, blauen und/oder grünen Spektralbereich aussendet. Die Leuchtstoffpartikel in der Vergußmasse wandeln einen Teil der aus diesem Spektralbereich stammenden Strahlung in Strahlung mit größerer Wellenlänge um, derart, daß das Halbleiterbauelement Mischstrahlung, insbesondere mischfarbiges Licht, bestehend aus dieser Strahlung und aus Strahlung aus dem ultravioletten, blauen und/oder grünen Spektralbereich aussendet. Das heißt beispielsweise, daß die Leuchtstoffpartikel einen Teil der vom Halbleiterkörper ausgesandten Strahlung spektral selektiv absorbiert und im längerwelligen Bereich emittiert. Bevorzugt weist die von dem Halbleiterkörper ausgesandte Strahlung bei einer Wellenlänge λ ≤ 520 nm ein relatives Intensitätsmaximum auf und liegt der von den Leuchtstoffpartikeln spektral selektiv absorbierte Wellenlängenbereich außerhalb dieses Intensitätsmaximums.

Ebenso können vorteilhafterweise auch mehrere verschiedenartige Leuchtstoffpartikelarten, die bei unterschiedlichen Wellenlängen emittieren, in der Vergußmasse dispergiert sein. Dies wird bevorzugt duruch unterschiedliche Dotierungen in unterschiedlichen Wirtsgittern erreicht. Dadurch ist es vorteilhafterweise möglich, vielfältige Farbmischungen und Farbtemperaturen des vom Bauelement emittierten Lichtes zu erzeugen. Von besonderem Interesse ist dies für vollfarbtaugliche LEDs.

Bei einer bevorzugten Verwendung der erfindungsgemäßen Vergußmasse ist ein strahlungsemittierender Halbleiterkörper (z. B. ein LED-Chip) zumindest teilweise von dieser umschlossen. Die Vergußmasse ist dabei bevorzugt gleichzeitig als Bauteilumhüllung (Gehäuse) genutzt. Der Vorteil eines Halbleiterbauelements gemäß dieser Ausführungsform besteht im wesentlichen darin, daß zu seiner Herstellung konventionelle, für die Herstellung von herkömmlichen Leuchtdioden (z. B. Radial-Leuchdioden) eingesetzte Produktionslinien verwendet werden können. Für die Bauteilumhüllung wird anstelle des bei herkömmlichen Leuchtdioden dafür verwendeten transparenten Kunststoffes einfach die Vergußmasse verwendet.

Mit der erfindungsgemäßen Vergußmasse kann auf einfache Weise mit einer einzigen farbigen Lichtquelle, insbesondere einer Leuchtdiode mit einem einzigen blaues Licht abstrahlenden Halbleiterkörper, mischfarbiges, insbesondere weißes Licht erzeugt werden. Um z. B. mit einem blaues Licht aussendenden Halbleiterkörper weißes Licht zu erzeugen, wird ein Teil der von dem Halbleiterkörper ausgesandten Strahlung mittels anorganischer Leuchtstoffpartikel aus dem blauen Spektralbereich in den zu Blau komplementärfarbigen gelben Spektralbereich konvertiert. Die Farbtemperatur oder Farbort des weißen Lichtes kann dabei durch geeignete Wahl des Leuchtstoffes, dessen Partikelgröße und dessen Konzentration, variiert werden. Darüber hinaus können auch Leuchtstoffmischungen eingesetzt werden, wodurch sich vorteilhafterweise der gewünschte Farbton des abgestrahlten Lichtes sehr genau einstellen läßt.

Besonders bevorzugt wird die Vergußmasse bei einem strahlungsemittierenden Halbleiterkörper verwendet, bei dem das ausgesandte Strahlungsspektrum bei einer Wellenlänge zwischen 420nm und 460 nm, insbesondere bei 430 nm (z. B. Halbleiterkörper auf der Basis von GaₓAl₁₋ₓN) oder 450 nm (z. B. Halbleiterkörper auf der Basis von GaₓIn₁₋ₓN) ein Intensitätsmaximum aufweist. Mit einem derartigen Halbleiterbauelement lassen sich vorteilhafterweise nahezu sämtliche Farben und Mischfarben der C.I.E.-Farbtafel erzeugen. An Stelle des strahlungsemittierenden Halbleiterkörpers aus elektrolumineszierendem Halbleitermaterial kann aber auch ein anderes elektrolumineszierendes Material, wie beispielsweise Polymermaterial, eingesetzt werden.

Besonders geeignet ist die Vergußmasse für ein lichtemittierendes Halbleiterbauelement (z. B. eine Leuchtdiode), bei dem der elektrolumineszierende Halbleiterkörper in einer Ausnehmung eines vorgefertigten eventuell bereits mit einem Leadframe versehenen Gehäuses angeordnet ist und die Ausnehmung mit der Vergußmasse versehen ist. Ein derartiges Halbleiterbauelement läßt sich in großer Stückzahl in herkömmlichen Produktionslinien herstellen. Hierzu muß lediglich nach der Montage des Halbleiterkörpers in das Gehäuse die Vergußmasse in die Ausnehmung gefüllt werden.

Ein weißes Licht abstrahlendes Halbleiterbauelement läßt sich mit der erfindungsgemäßen Vergußmasse vorteilhafterweise dadurch herstellen, daß der Leuchtstoff so gewählt wird, daß eine von dem Halbleiterkörper ausgesandte blaue Strahlung in komplementäre Wellenlängenbereiche, insbesondere Blau und Gelb, oder zu additiven Farbtripeln, z. B. Blau, Grün und Rot umgewandelt wird. Hierbei wird das gelbe bzw. das grüne und rote Licht über die Leuchtstoffe erzeugt. Der Farbton (Farbort in der CIE-Farbtafel) des dadurch erzeugten weißen Lichts kann dabei durch geeignete Wahl des/der Leuchtstoffes/e hinsichtlich Mischung und Konzentration variiert werden.

Um die Durchmischung der von einem elektrolumineszierenden Halbleiterkörper ausgesandten Strahlung mit der vom Leuchtstoff konvertierten Strahlung und damit die Farbhomogenität des vom Bauelement abgestrahlten Lichtes zu verbessern, ist bei einer vorteilhaften Ausgestaltung der erfindungsgemäßen Vergußmasse zusätzlich ein im Blauen lumineszierender Farbstoff zugefügt, der eine sogenannte Richtcharakteristik der von dem Halbleiterkörper ausgesandten Strahlung abschwächt. Unter Richtcharakteristik ist zu verstehen, daß die von dem Halbleiterkörper ausgesandte Strahlung eine bevorzugte Abstrahlrichtung aufweist.

Ein weißes Licht abstrahlendes erfindungsgemäßes Halbleiterbauelement mit einem blaues Licht emittierenden elektrolumineszierenden Halbleiterkörper läßt sich besonders bevorzugt dadurch realisieren, daß dem für die Vergußmasse verwendeten Epoxidharz der anorganische Leuchtstoff YAG:Ce (Y₃Al₅O₁₂:Ce³⁺) beigemischt ist. Ein Teil einer von dem Halbleiterkörper ausgesandten blauen Strahlung wird von dem anorganischen Leuchtstoff Y₃Al₅O₁₂:Ce³⁺ in den gelben Spektralbereich und somit in einen zur Farbe Blau komplementärfarbigen Wellenlängenbereich verschoben. Der Farbton (Farbort in der CIE-Farbtafel) des weißen Lichts kann dabei durch geeignete Wahl der Farbstoffkonzentration variiert werden.

Der Vergußmasse können zusätzlich lichtstreuende Partikel, sogenannte Diffusoren zugesetzt sein. Hierdurch läßt sich vorteilhafterweise der Farbeindruck und die Abstrahlcharakteristik des Halbleiterbauelements weiter optimieren.

Mit der erfindungsgemäßen Vergußmasse kann vorteilhafterweise auch eine von einem elektrolumineszierenden Halbleiterkörper neben der sichtbaren Strahlung ausgesandte ultraviolette Strahlung in sichtbares Licht umgewandelt werden. Dadurch wird die Helligkeit des vom Halbleiterkörper ausgesandten Lichts deutlich erhöht.

Ein besonderer Vorteil von erfindungsgemäßen weißes Licht abstrahlenden Halbleiterbauelementen, bei denen als Lumineszenzkonversionsfarbstoff insbesondere YAG:Ce verwendet ist, besteht darin, daß dieser Leuchtstoff bei Anregung mit blauem Licht eine spektrale Verschiebung von ca. 100 nm zwischen Absorption und Emission bewirkt. Dies führt zu einer wesentlichen Reduktion der Reabsorption des vom Leuchtstoff emittierten Lichtes und damit zu einer höheren Lichtausbeute. Außerdem besitzt YAG:Ce vorteilhafterweise eine hohe thermische und photochemische (z. B. UV-) Stabilität (wesentlich höher als organische Leuchtstoffe), so daß auch Weiß leuchtende Dioden für Außenanwendung und/oder hohe Temperaturbereiche herstellbar sind.

YAG:Ce hat sich bislang hinsichtlich Reabsorption, Lichtausbeute, thermischer und photochemischer Stabilität und Verarbeitbarkeit als am besten geeigneter Leuchtstoff herausgestellt. Denkbar ist jedoch auch die Verwendung von anderen Ce-dotierten Phosphoren, insbesondere Ce-dotierten Granattypen.

Die Wellenlängenkonversion der Primärstrahlung wird durch die Kristallfeldaufspaltung der aktiven Übergangsmetallzentren im Wirtsgitter bestimmt. Durch die Substitution von Y durch Gd und/oder Lu bzw. Al durch Ga im Y₃Al₅O₁₂-Granatgitter können die Emissionswellenlängen in unterschiedlicher Weise verschoben werden, wie außerdem durch die Art der Dotierung. Durch die Substitution von Ce³⁺-Zentren durch Eu³⁺ und/oder Cr³⁺ können entsprechende Shifts erzeugt werden. Entsprechende Dotierungen mit Nd³⁺ und Er³⁺ ermöglichen sogar aufgrund der größeren Ionenradien und damit geringeren Kristallfeldaufspaltungen IRemittierende Bauelemente.

Weitere Merkmale, Vorteile und Zweckmäßigkeiten der Erfindung ergeben sich aus der nachfolgenden Beschreibung von zwei Ausführungsbeispielen in Verbindung mit den Figuren 1 bis8. Es zeigen:
Figur 1 eine schematische Schnittansicht eines ersten Halbleiterbauelements mit einer erfindungsgemäßen Vergußmasse;
Figur 2 eine schematische Schnittansicht eines zweiten Halbleiterbauelements mit einer erfindungsgemäßen Vergußmasse;
Figur 3 eine schematische Schnittansicht eines dritten Halbleiterbauelements mit einer erfindungsgemäßen Vergußmasse;
Figur 4 eine schematische Schnittansicht eines vierten Halbleiterbauelements mit einer erfindungsgemäßen Vergußmasse;
Figur 5 eine schematische Schnittansicht eines fünften Halbleiterbauelements mit einer erfindungsgemäßen Vergußmasse;
Figur 6 eine schematische Darstellung eines Emissionsspektrums eines blaues Licht abstrahlenden Halbleiterkörpers mit einer Schichtenfolge auf der Basis von GaN;
Figur 7 eine schematische Darstellung der Emissionsspektren zweier Halbleiterbauelemente mit einer erfindungsgemäßen Vergußmasse, die weißes Licht abstrahlen, und
Figur 8 eine schematische Darstellung der Emissionsspektren von weiteren Halbleiterbauelementen, die weißes Licht abstrahlen.

In den verschiedenen Figuren sind gleiche bzw. gleichwirkende Teile immer mit denselben Bezugszeichen bezeichnet.

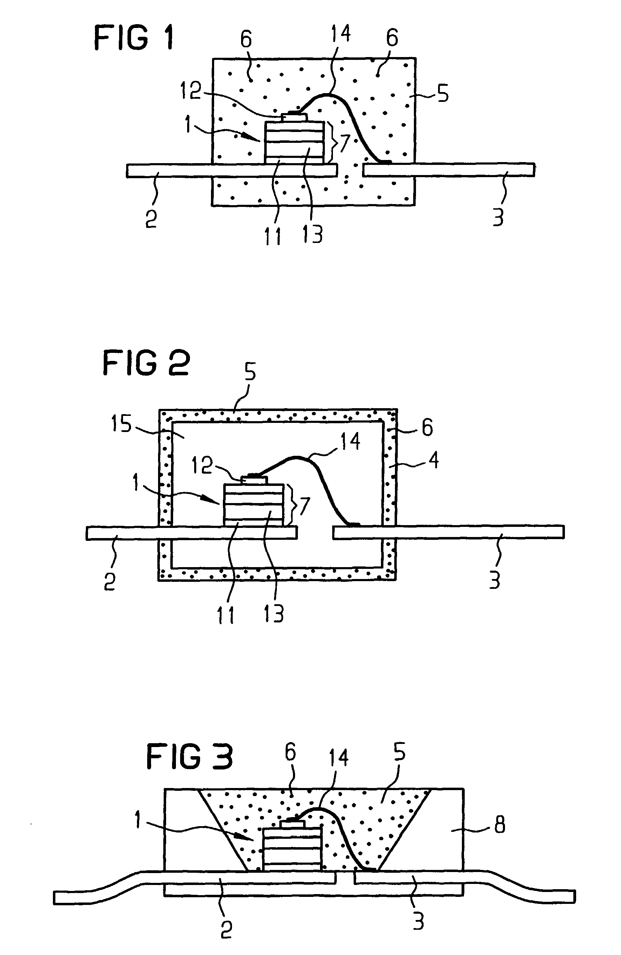

Bei dem lichtemittierenden Halbleiterbauelement von Figur 1 ist der Halbleiterkörper 1 mittels eines elektrisch leitenden Verbindungsmittels, z. B. ein metallisches Lot oder ein Klebstoff, mit seinem Rückseitenkontakt 11 auf einem ersten elektrischen Anschluß 2 befestigt. Der Vorderseitenkontakt 12 ist mittels eines Bonddrahtes 14 mit einem zweiten elektrischen Anschluß 3 verbunden.

Die freien Oberflächen des Halbleiterkörpers 1 und Teilbereiche der elektrischen Anschlüsse 2 und 3 sind unmittelbar von einer gehärteten, wellenlängenkonvertierenden Vergußmasse 5 umschlossen. Diese weist bevorzugt auf: Epoxidgießharz 80 - 90 Gew%, Leuchtstoffpigmente (YAG:Ce) ≤ 15 Gew%, Diethylenglycolmonomethylether ≤ 2 Gew%, Tegopren 6875-45 ≤ 2 Gew%, Aerosil 200 ≤ 5 Gew%

Das in Figur 2 dargestellte Ausführungsbeispiel eines erfindungsgemäßen Halbleiterbauelements unterscheidet sich von dem der Figur 1 dadurch, daß der Halbleiterkörper 1 und Teilbereiche der elektrischen Anschlüsse 2 und 3 anstatt von einer wellenlängenkonvertierenden Vergußmasse von einer transparenten Umhüllung 15 umschlossen sind. Diese transparente Umhüllung 15 bewirkt keine Wellenlängenänderung der von dem Halbleiterkörper 1 ausgesandten Strahlung und besteht beispielsweise aus einem in der Leuchtdiodentechnik herkömmlich verwendeten Epoxid-, Silikon- oder Acrylatharz oder aus einem anderen geeigneten strahlungsdurchlässigen Material wie z. B. anorganisches Glas.

Auf diese transparente Umhüllung 15 ist eine Schicht 4 aufgebracht, die aus einer wellenlängenkonvertierenden Vergußmasse, wie in der Figur 2 dargestellt, die gesamte Oberfläche der Umhüllung 15 bedeckt. Ebenso denkbar ist, daß die Schicht 4 nur einen Teilbereich dieser Oberfläche bedeckt. Die Schicht 4 besteht beispielsweise aus einem transparenten Epoxidharz, das mit Leuchtstoffpartikeln 6 versetzt ist. Auch hier eignet sich als Leuchtstoff für ein weiß leuchtendes Halbleiterbauelement bevorzugt YAG:Ce.

Bei dem in Figur 3 dargestellten besonders bevorzugten mit der erfindungsgemäßen Vergußmasse versehenen Bauelement, sind der erste und zweite elektrische Anschluß 2,3 in ein lichtundurchlässiges evtl. vorgefertigtes Grundgehäuse 8 mit einer Ausnehmung 9 eingebettet. Unter "vorgefertigt" ist zu verstehen, daß das Grundgehäuse 8 bereits an den Anschlüssen 2,3 beispielsweise mittels Spritzguß fertig ausgebildet ist, bevor der Halbleiterkörper auf den Anschluß 2 montiert wird. Das Grundgehäuse 8 besteht beispielsweise aus einem lichtundurchlässigen Kunststoff und die Ausnehmung 9 ist hinsichtlich ihrer Form als Reflektor 17 für die vom Halbleiterkörper im Betrieb ausgesandte Strahlung (ggf. durch geeignete Beschichtung der Innenwände der Ausnehmung 9) ausgebildet. Solche Grundgehäuse 8 werden insbesondere bei auf Leiterplatten oberflächenmontierbaren Leuchtdioden verwendet. Sie werden vor der Montage der Halbleiterkörper auf ein die elektrischen Anschlüsse 2,3 aufweisendes Leiterband (Leadframe) z. B. mittels Spritzgießen aufgebracht.

Die Ausnehmung 9 ist mit einer Vergußmasse 5, deren Zusammensetzung der oben in Verbindung mit der Beschreibung zu Figur 1 angegebenen entspricht, gefüllt.

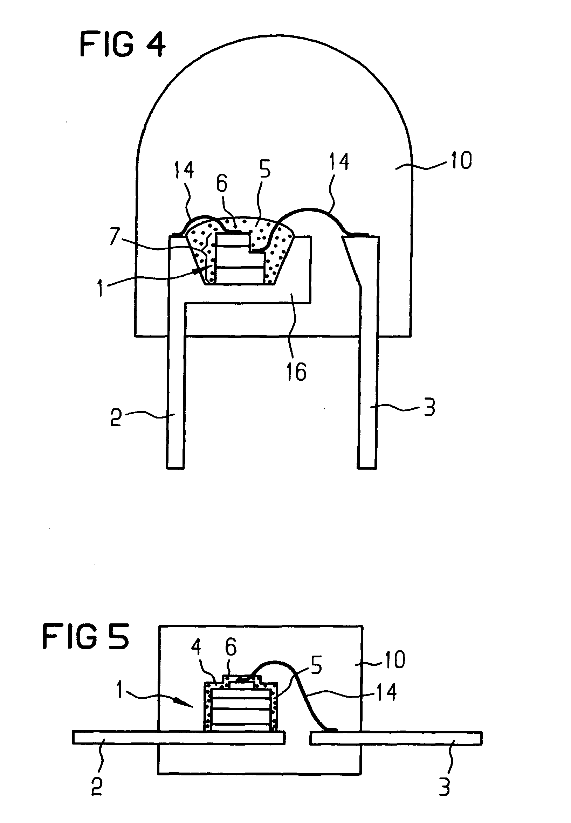

In Figur 4 ist eine sogenannte Radialdiode dargestellt. Hierbei ist der elektrolumineszierende Halbleiterkörper 1 in einem als Reflektor ausgebildeten Teil 16 des ersten elektrischen Anschlußes 2 beispielsweise mittels Löten oder Kleben befestigt. Derartige Gehäusebauformen sind in der Leuchtdiodentechnik bekannt und bedürfen von daher keiner näheren Erläuterung.

Die freien Oberflächen des Halbleiterkörpers 1 sind unmittelbar von einer Vergußmasse 5 mit Leuchtstoffpartikel 6 bedeckt, die wiederum von einer weiteren transparenten Umhüllung 10 umgeben ist.

Der Vollständikeit halber sei an dieser Stelle angemerkt, daß selbstverständlich auch bei der Bauform nach Figur 4 analog zu dem Bauelement gemäß Figur 1 eine einstückige Umhüllung, bestehend aus gehärteter Vergußmasse 5 mit Leuchtstoffpartikel 6, verwendet sein kann.

Bei dem Ausführungsbeispiel von Figur 5 ist eine Schicht 4 (mögliche Materialien wie oben angegeben) direkt auf den Halbleiterkörper 1 aufgebracht. Dieser und Teilbereiche der elektrischen Anschlüsse 2,3 sind von einer weiteren transparenten Umhüllung 10 umschlossen, die keine Wellenlängenänderung der durch die Schicht 4 hindurchgetretenen Strahlung bewirkt und beispielsweise aus einem in der Leuchtdiodentechnik verwendbaren transparenten Epoxidharz oder aus Glas gefertigt ist.

Solche, mit einer Schicht 4 versehenen Halbleiterkörper 1 ohne Umhüllung können natürlich vorteilhafterweise in sämtlichen aus der Leuchtdiodentechnik bekannten Gehäusebauformen (z. B. SMD-Gehäuse, Radial-Gehäuse (man vergleiche Figur 4) verwendet sein.

Bei sämtlichen der oben beschriebenen Bauelemente kann zur Optimierung des Farbeindrucks des abgestrahlten Lichts sowie zur Anpassung der Abstrahlcharakteristik die Vergußmasse 5, ggf. die transparente Umhüllung 15, und/oder ggf. die weitere transparente Umhüllung 10 lichtstreuende Partikel, vorteilhafterweise sogenannte Diffusoren aufweisen. Beispiele für derartige Diffusoren sind mineralische Füllstoffe, insbesondere CaF₂, TiO₂, SiO₂, CaCO₃ oder BaSO₄ oder auch organische Pigmente. Diese Materialien können auf einfache Weise Epoxidharzen zugesetzt werden.

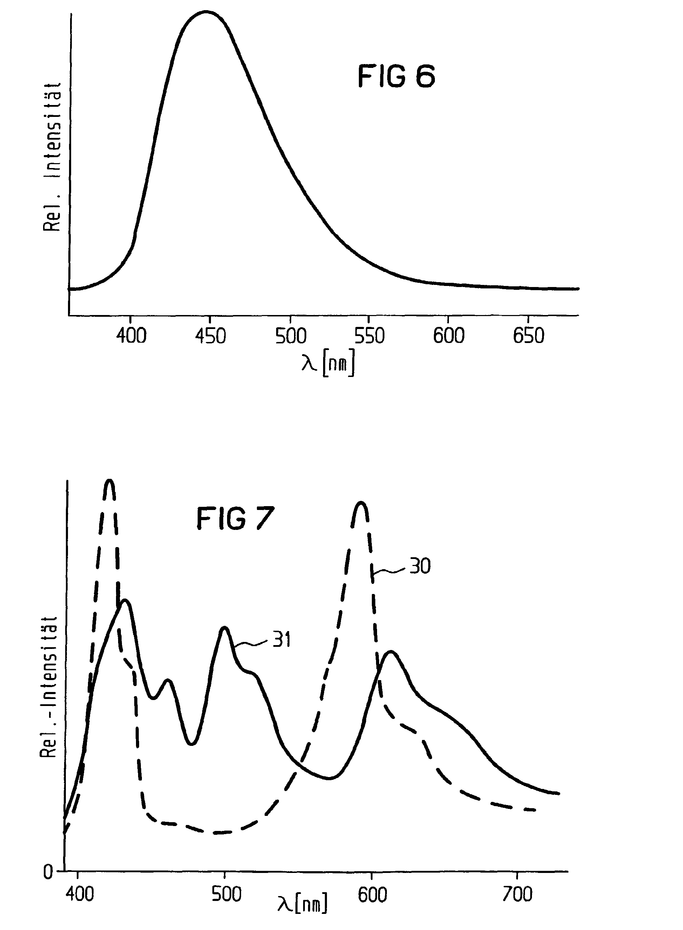

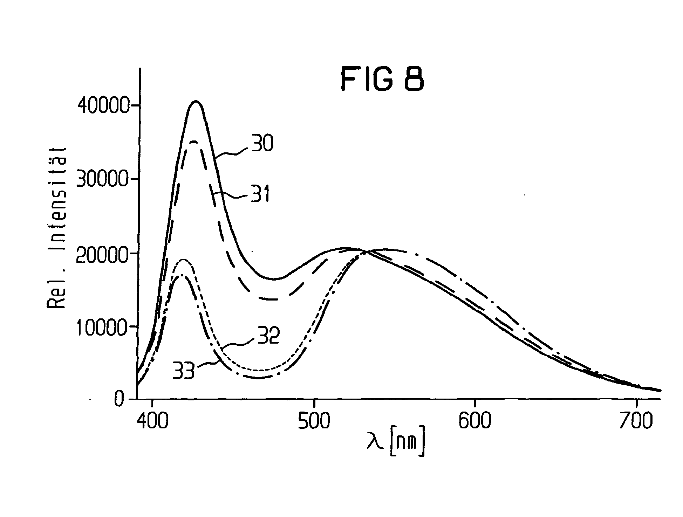

In den Figuren 6, 7 und 8 sind Emissionsspektren eines blaues Licht abstrahlenden Halbleiterkörpers (Fig. 6) (Lumineszenzmaximum bei λ ∼ 430 nm) bzw. von mittels eines solchen Halbleiterkörpers hergestellten Weiß leuchtenden Halbleiterbauelementen (Fig. 7 und 8) gezeigt. An der Abszisse ist jeweils die Wellenänge λ in nm und auf der Ordinate ist jeweils eine relative Elektrolumineszenz(EL)-Intensität aufgetragen.

Von der vom Halbeiterkörper ausgesandten Strahlung nach Figur 6 wird nur ein Teil in einen längerwelligen Wellenlängenbereich konvertiert, so daß als Mischfarbe weißes Licht entsteht. Die gestrichelte Linie 30 in Figur 7 stellt ein Emissionsspektrum von einem Halbleiterbauelement dar, das Strahlung aus zwei komplementären Wellenlängenbereichen (Blau und Gelb) und damit insgesamt weißes Licht aussendet. Das Emissionsspektrum weist hier bei Wellenlängen zwischen ca. 400 und ca. 430 nm (Blau) und zwischen ca. 550 und ca. 580 nm (Gelb) je ein Maximum auf. Die durchgezogene Linie 31 repräsentiert das Emissionsspektrum eines Halbleiterbauelements, das die Farbe Weiß aus drei Wellenlängenbereichen (additives Farbtripel aus Blau, Grün und Rot) mischt. Das Emissionsspektrum weist hier beispielsweise bei den Wellenlängen von ca. 430 nm (Blau), ca. 500 nm (Grün) und ca. 615 nm (Rot) je ein Maximum auf.

Figur 8 zeigt ein Emissionsspektrum eines Weiß leuchtendes Halbleiterbauelement, das mit einem ein Emissions-Spektrum gemäß Figur 6 aussendenden Halbleiterkörper versehen ist und bei dem als Leuchtstoff YAG:Ce verwendet ist. Von der vom Halbeiterkörper ausgesandten Strahlung nach Figur 6 wird nur ein Teil in einen längerwelligen Wellenlängenbereich konvertiert, so daß als Mischfarbe weißes Licht entsteht. Die verschiedenartig gestrichelten Linien 30 bis 33 von Figur 8 stellen Emissionsspektren von erfindungsgemäßen Halbleiterbauelementen dar, bei denen das Epoxidharz der Vergußmasse 5 unterschiedliche YAG:Ce-Konzentrationen aufweist. Jedes Emissionsspektrum weist zwischen λ = 420 nm und λ = 430 nm, also im blauen Spektralbereich, und zwischen λ = 520 nm und λ = 545 nm, also im grünen Spektralbereich, jeweils ein Intensitätsmaximum auf, wobei die Emissionsbanden mit dem längerwelligen Intensitätsmaximum zu einem großen Teil im gelben Spektralbereich liegen. Das Diagramm von Figur 12 verdeutlicht, daß bei dem erfindungsgemäßen Halbleiterbauelement auf einfache Weise durch Veränderung der Leuchtstoffkonzentration im Epoxidharz der CIE-Farbort des weißen Lichtes verändert werden kann.

Die Erläuterung der Erfindung anhand der oben beschriebenen Bauelemente ist natürlich nicht als Beschränkung der Erfindung auf diese zu betrachten. Als Halbleiterkörper, wie beispielsweise Leuchtdioden-Chips oder Laserdioden-Chips, ist beispielsweise auch eine Polymer-LED zu verstehen, die ein enstprechendes Strahlungsspektrum aussendet.

## Patentansprüche

1. Wellenlängenkonvertierende Vergußmasse (5) auf der Basis eines transparenten Epoxidgießharzes für ein elektrolumineszierendes Bauelement mit einem ultraviolettes, blaues oder grünes Licht aussendenden Körper (1), bei der im transparenten Epoxidgießharz ein anorganisches Leuchtstoffpigmentpulver mit Leuchtstoffpigmenten (6) aus der Gruppe der mit seltenen Erden dotierten Granate, mit seltenen Erden dotierten Thiogallate, mit seltenen Erden dotierten Aluminate und/oder mit seltenen Erden dotierten Orthosilikate dispergiert ist und die Leuchtstoffpigmente Korngrößen ≤ 20 µm und ein d₅₀ ≤ 5 µm aufweisen.

2. Vergußmasse nach Anspruch 1, bei der die Leuchtstoffpigmente (6) kugelförmig oder schuppenförmig sind.

3. Vergußmasse nach Anspruch 1 oder 2, bei der der mittlere Korndurchmesser d₅₀ der Leuchtstoffpigmente (6) zwischen 1 und 2 µm liegt.

4. Vergußmasse nach einem der Ansprüche 1 bis 3, die zusammengesetzt ist aus:
a) Epoxidgießharz ≥ 60 Gew%
b) Leuchtstoffpigmente > 0 und ≤ 25 Gew%
c) Thixotropiermittel > 0 und ≤ 10 Gew%
d) mineralischem Diffusor > 0 und ≤ 10 Gew%
e) Verarbeitungshilfsmittel > 0 und ≤ 3 Gew%
f) Hydrophobiermittel > 0 und ≤ 3 Gew%
g) Haftvermittler > 0 und ≤ 2 Gew%.

5. Vergußmasse nach einem der Ansprüche 1 bis 4, bei der der Eisengehalt ≤ 20ppm ist.

6. Vergußmasse nach einem der Ansprüche 1 bis 5, bei der die Leuchtstoffpigmente (6) mit einem Silikon-Coating versehen sind.

7. Verfahren zum Herstellen einer Vergußmasse auf der Basis eines transparenten Epoxidgießharzes für ein elektrolumineszierendes Bauelement mit einem ultraviolettes, blaues oder grünes Licht aussendenden Körper (1), bei dem ein anorganisches Leuchtstoffpigmentpulver, mit Leuchtstoffpigmenten (6) aus der Gruppe der mit seltenen Erden dotierten Granate, mit seltenen Erden dotierten Thiogallate, mit seltenen Erden dotierten Aluminate und/oder mit seltenen Erden dotierten Orthosilikate, mit Korngrößen ≤ 20 µm und mit ein d₅₀ ≤ 5 µm hergestellt wird und in der Vergussmasse dispergiert wird.

8. Verfahren nach Anspruch 7, bei dem das Leuchtstoffpigmentpulver bei einer Temperatur ≥ 200°C getempert wird.

9. Verfahren nach Anspruch 7 oder 8, bei dem das Leuchtstoffpigmentpulver in einem höher siedenden Alkohol geschlämmt und anschließend getrocknet wird.

10. Verfahren nach einem der Ansprüche 7 bis 9, bei dem dem Leuchtstoffpigmentpulver ein hydrophobierendes Silikonwachs zugegeben wird.

11. Verfahren nach einem der Ansprüche 7 bis 10, bei dem das Leuchstoffpigmentpulver mit Alkoholen, Glykolethern und Silikonen bei erhöhten Temperaturen oberflächenmodifiziert wird.

12. Verfahren nach einem der Ansprüche 7 bis 11, bei dem ein Leuchtstoffpigmentpulver mit einem mittleren Korndurchmesser d₅₀ zwischen 1 und 2 µm hergestellt wird.

13. Verfahren nach einem der Ansprüche 7 bis 12, bei dem
a) Epoxidgießharz ≥ 60 Gew%
b) Leuchtstoffpigmente > 0 und ≤ 25 Gew%
c) Thixotropiermittel > 0 und ≤ 10 Gew%
d) mineralischem Diffusor > 0 und ≤ 10 Gew%
e) Verarbeitungshilfsmittel > 0 und ≤ 3 Gew%
f) Hydrophobiermittel > 0 und ≤ 3 Gew%
g) Haftvermittler > 0 und ≤ 2 Gew%
vermischt werden.

14. Verfahren nach einem der Ansprüche 7 bis 13, bei dem die Leuchtstoffpigmente (6) mit einem Silikon-Coating versehen werden.

15. Verfahren zum Herstellen eines lichtabstrahlenden Halbleiterbauelements, bei dem ein Halbleiterkörper (1), der eine Halbleiterschichtenfolge (7) aufweist, die geeignet ist, im Betrieb des Halbleiterbauelements elektromagnetische Strahlung aus dem ultravioletten, blauen und/oder grünen Spektralbereich auszusenden, zumindest teilweise mit einer Vergußmasse gemäß einem der Patentansprüche 1 bis 6 umschlossen wird.

16. Verfahren zum Herstellen eines lichtabstrahlenden Halbleiterbauelements, bei dem auf einen Halbleiterkörper (1), der eine Halbleiterschichtenfolge (7) aufweist, die geeignet ist, im Betrieb des Halbleiterbauelements elektromagnetische Strahlung aus dem ultravioletten, blauen und/oder grünen Spektralbereich auszusenden, eine Schicht (4) aus einer Vergußmasse gemäß einem der Patentansprüche 1 bis 6 aufgebracht wird und der Halbleiterkörper (1) in ein SMD-Gehäuse oder ein Radial-Gehäuse montiert wird.

17. Lichtabstrahlendes Halbleiterbauelement, hergestellt mit einer wellenlängenkonvertierenden Vergußmasse nach einem der Ansprüche 1 bis 6, mit einem Halbleiterkörper (1), der eine Halbleiterschichtenfolge (7) aufweist, die geeignet ist, im Betrieb des Halbleiterbauelements elektromagnetische Strahlung aus dem ultravioletten, blauen und/oder grünen Spektralbereich auszusenden,
und die Leuchtstoffpigmente einen Teil der aus diesem Spektralbereich stammenden Strahlung in Strahlung mit größerer Wellenlänge umwandelt, derart, daß das Halbleiterbauelement Mischstrahlung, insbesondere mischfarbiges Licht, bestehend aus dieser Strahlung und aus Strahlung aus dem ultravioletten, blauen und/oder grünen Spektralbereich aussendet.

18. Lichtabstrahlendes Halbleiterbauelement nach Anspruch 17, bei dem die Vergußmasse zumindest einen Teil des Halbleiterkörpers (1) umschließt.

19. Lichtabstrahlendes Halbleiterbauelement nach Anspruch 17 oder 18, bei dem das vom Halbleiterkörper (1) ausgesandte Strahlungsspektrum bei einer Wellenlänge kleiner oder gleich 520 nm ein Intensitätsmaximum aufweist und ein von den Leuchtstoffpigmenten spektral selektiv absorbierter Wellenlängenbereich außerhalb dieses Intensitätsmaximums liegt.

20. Lichtabstrahlendes Halbleiterbauelement nach Anspruch 17 oder 18, bei dem das vom Halbleiterkörper (1) ausgesandte Strahlungsspektrum bei einer Wellenlänge zwischen 420nm und 460 nm ein Intensitätsmaximum aufweist.

21. Lichtabstrahlendes Halbleiterbauelement nach Anspruch 17 oder 18, bei dem das vom Halbleiterkörper (1) ausgesandte Strahlungsspektrum bei 430 nm oder 450 nm ein Intensitätsmaximum aufweist.

22. Lichtabstrahlendes Halbleiterbauelement nach Anspruch 19, 20 oder 21, bei dem der Halbleiterkörper auf der Basis von GaₓAl₁₋ₓN oder auf der Basis von GaₓIn₁₋ₓN hergestellt ist.

23. Lichtabstrahlendes Halbleiterbauelement nach einem der Ansprüche 17 bis 22, bei dem in der Vergußmasse (5) mehrere verschiedene Leuchtstoffpartikelarten, die bei unterschiedlichen Wellenlängen emittieren, dispergiert sind.

24. Lichtabstrahlendes Halbleiterbauelement nach einem der Ansprüche 17 bis 22, bei dem die Vergußmasse (5) hinsichtlich Wirtsgitter und Art und Ausmaß der Dotierung mit verschiedenartigen Leuchtstoffpigmenten (6) versehen ist.

25. Lichtabstrahlendes Halbleiterbauelement nach einem der Ansprüche 17 bis 24, bei dem der Halbleiterkörper (1) in einer Ausnehmung (9) eines Grundgehäuses (8) angeordnet ist und daß die Ausnehmung (9) zumindest teilweise mit der Vergußmasse (5) gefüllt ist.

26. Lichtabstrahlendes Halbleiterbauelement nach einem der Ansprüche 17 bis 24, bei dem der Halbleiterkörper (1) in einem als Reflektor ausgebildeten Teil (16) eines elektrischen Anschlusses (2) befestigt ist, der zumindest teilweise mit der Vergußmasse (5) gefüllt ist.

27. Lichtabstrahlendes Halbleiterbauelement nach einem der Ansprüche 17 bis 24, bei dem auf dem Halbleiterkörper (1) eine Schicht (4) aus der Vergußmasse aufgebracht ist.

28. Lichtabstrahlendes Halbleiterbauelement nach einem der Ansprüche 25 bis 27, bei dem die freien Oberflächen des Halbleiterkörpers (1) mit der Vergußmasse (5) bedeckt sind, auf der wiederum eine weitere transparente Umhüllung (10) aufgebracht ist.

29. Lichtabstrahlendes Halbleiterbauelement nach einem der Ansprüche 17 bis 28, das weißes Licht aussendet, indem der Halbleiterkörper blaue Strahlung aussendet und der Leuchtstoff blaue Strahlung in gelbe Strahlung umwandelt.

30. Lichtabstrahlendes Halbleiterbauelement nach Anspruch 29, bei dem das Emissionsspektrum zwischen ca. 400 und ca. 430 nm und zwischen ca. 550 und ca. 580 nm je ein Maximum aufweist.

31. Lichtabstrahlendes Halbleiterbauelement nach einem der Ansprüche 17 bis 28, das weißes Licht aussendet, indem der Halbleiterkörper blaue Strahlung aussendet und der Leuchtstoff blaue Strahlung in grüne und in rote Strahlung umwandelt.

32. Lichtabstrahlendes Halbleiterbauelement nach Anspruch 31, bei dem das Emissionsspektrum bei ca. 430 nm, bei ca. 500 nm und bei ca. 615 nm je ein Maximum aufweist.

33. Lichtabstrahlendes Halbleiterbauelement nach einem der Ansprüche 17 bis 32, bei dem der Vergußmasse zusätzlich lichtstreuende Partikel zugesetzt sind.

34. Lichtabstrahlendes Halbleiterbauelement nach Anspruch 28, bei dem der transparenten Umhüllung (10) lichtstreuende Partikel zugesetzt sind.

35. Lichtabstrahlendes Halbleiterbauelement nach einem der Ansprüche 17 bis 34, bei dem der Halbleiterkörper neben einer sichtbaren Strahlung ultraviolette Strahlung aussendet, die von der Vergußmasse in sichtbare Strahlung umgewandelt wird.

36. Halbleiterkörper (1), der eine Halbleiterschichtenfolge (7) aufweist, die geeignet ist, im Betrieb des Halbleiterbauelements elektromagnetische Strahlung aus dem ultravioletten, blauen und/oder grünen Spektralbereich auszusenden, auf dem eine Schicht (4) aus einer Vergußmasse gemäß einem der Patentansprüche 1 bis 6 aufgebracht ist.

37. Halbleiterkörper nach Anspruch 36, der auf der Basis von GaₓAl₁₋ₓN oder auf der Basis von GaₓIn₁₋ₓN hergestellt ist.

## Claims

1. Wavelength-converting casting compound (5) based on a transparent epoxy casting resin for an electroluminescent component with a body (1) emitting ultraviolet, blue or green light, in which an inorganic luminescent pigment powder with luminescent pigments (6) from the group of garnets doped with rare earths, thiogallates doped with rare earths, aluminates doped with rare earths and/or orthosilicates doped with rare earths is dispersed in the transparent epoxy casting resin, and the luminescent pigments have particle sizes ≤ 20 µm and a d₅₀ ≤ 5 µm.

2. Casting compound according to Claim 1, in which the luminescent pigments (6) are spherical or in the form of flakes.

3. Casting compound according to Claim 1 or 2, in which the median particle diameter d₅₀ of the luminescent pigments (6) lies between 1 and 2 µm.

4. Casting compound according to one of Claims 1 to 3, which is made up of:
a) epoxy casting resin ≥ 60% by weight
b) luminescent pigments > 0 and ≤ 25% by weight
c) thixotropic agent > 0 any ≤ 10% by weight
d) mineral diffusor > 0 and ≤ 10% by weight
e) processing auxiliary > 0 and ≤ 3% by weight
f) hydrophobing agent > 0 and ≤ 3% by weight
g) adhesion promoter > 0 and ≤ 2% by weight.

5. Casting compound according to one of Claims 1 to 4, in which the iron content is ≤ 20 ppm.

6. Casting compound according to one of Claims 1 to 5, in which the luminescent pigments (6) are provided with a silicone coating.

7. Method for producing a casting compound based on a transparent epoxy casting resin for an electroluminescent component with a body (1) emitting ultraviolet, blue or green light, in which an inorganic luminescent pigment powder with luminescent pigments (6) from the group of garnets doped with rare earths, thiogallates doped with rare earths, aluminates doped with rare earths and/or orthosilicates doped with rare earths which have particle sizes ≤ 20 µm and a d₅₀ ≤ 5 µm is produced and is dispersed in the casting compound.

8. Method according to Claim 7, in which the luminescent pigment powder is heat-treated at a temperature ≥ 200°C.

9. Method according to Claim 7 or 8, in which the luminescent pigment powder is washed in a higher-boiling alcohol and then dried.

10. Method according to one of Claims 7 to 9, in which a hydrophobing silicone wax is added to the luminescent pigment powder.

11. Method according to one of Claims 7 to 10, in which the luminescent pigment powder is surface-modified with alcohols, glycol ethers and silicones at elevated temperatures.

12. Method according to one of Claims 7 to 11, in which a luminescent pigment powder having a mean particle diameter d₅₀ between 1 and 2 µm is produced.

13. Method according to one of Claims 7 to 12, in which
a) epoxy casting resin ≥ 60% by weight
b) luminescent pigments > 0 and ≤ 25% by weight
c) thixotropic agent > 0 and ≤ 10% by weight
d) mineral diffusor > 0 and ≤ 10% by weight
e) processing auxiliary > 0 and ≤ 3% by weight
f) hydrophobing agent > 0 and ≤ 3% by weight
g) adhesion promoter > 0 and ≤ 2% by weight are mixed.

14. Method according to one of Claims 7 to 13, in which the luminescent pigments (6) are provided with a silicone coating.

15. Method for producing a light-emitting semiconductor component, in which a semiconductor body (1), which has a semiconductor layer sequence (7) that is suitable for emitting electromagnetic radiation from the ultraviolet, blue and/or green spectral range during operation of the semiconductor component, is at least partially encased by a casting compound according to one of Patent Claims 1 to 6.

16. Method for producing a light-emitting semiconductor component, in which a layer (4) composed of a casting compound according to one of Patent Claims 1 to 6 is applied to a semiconductor body (1), which has a semiconductor layer sequence (7) that is suitable for emitting electromagnetic radiation from the ultraviolet, blue and/or green spectral range during operation of the semiconductor component, and the semiconductor body (1) is mounted into an SMD package or a radial package.

17. Light-emitting semiconductor component, produced using a wavelength-converting casting compound according to one of Patent Claims 1 to 6, with a semiconductor body (1), which has a semiconductor layer sequence (7) that is suitable for emitting electromagnetic radiation from the ultraviolet, blue and/or green spectral range during operation of the semiconductor component,
and the luminescent pigments convert a part of the radiation coming from this spectral range into radiation having longer wavelength, such that the semiconductor component emits mixed radiation, in particular mixed-colour light, consisting of this radiation and of radiation from the ultraviolet, blue and/or green spectral range.

18. Light-emitting semiconductor component according to Claim 17, in which the casting compound encases at least a part of the semiconductor body (1).

19. Light-emitting semiconductor component according to Claim 17 or 18, in which the radiation spectrum emitted by the semiconductor body (1) has an intensity maximum at a wavelength of less than or equal to 520 nm and a wavelength range that is spectrally selectively absorbed by the luminescent pigments lies outside said intensity maximum.

20. Light-emitting semiconductor component according to Claim 17 or 18, in which the radiation spectrum emitted by the semiconductor body (1) has an intensity maximum at a wavelength of between 420 nm and 460 nm.

21. Light-emitting semiconductor component according to Claim 17 or 18, in which the radiation spectrum emitted by the semiconductor body (1) has an intensity maximum at 430 nm or 450 nm.

22. Light-emitting semiconductor component according to Claim 19, 20 or 21, in which the semiconductor body is produced on the basis of GaₓAl₁₋ₓN or on the basis of GaₓIn₁₋ₓN.

23. Light-emitting semiconductor component according to one of Claims 17 to 22, in which a plurality of different luminescent particle types which emit at different wavelengths are dispersed in the casting compound (5).

24. Light-emitting semiconductor component according to one of Claims 17 to 22, in which the casting compound (5) is provided with various luminescent pigments (6) that differ with respect to host lattice and type and level of the doping.

25. Light-emitting semiconductor component according to one of Claims 17 to 24, in which the semiconductor body (1) is arranged in a recess (9) of a base package (8), and the recess (9) is filled at least partially with the casting compound (5).

26. Light-emitting semiconductor component according to one of Claims 17 to 24, in which the semiconductor body (1) is fixed in a part (16) - embodied as a reflector - of an electrical terminal (2) which is filled at least partially with the casting compound (5).

27. Light-emitting semiconductor component according to one of Claims 17 to 24, in which a layer (4) composed of the casting compound is applied on the semiconductor body (1).

28. Light-emitting semiconductor component according to one of Claims 25 to 27, in which the free surfaces of the semiconductor body (1) are covered with the casting compound (5), on which a further transparent encapsulation (10) is applied.

29. Light-emitting semiconductor component according to one of Claims 17 to 28, which emits white light by virtue of the fact that the semiconductor body emits blue radiation and the luminescent material converts blue radiation into yellow radiation.

30. Light-emitting semiconductor component according to Claim 29, in which the emission spectrum has a respective maximum between approximately 400 and approximately 430 nm and between approximately 550 and approximately 580 nm.

31. Light-emitting semiconductor component according to one of Claims 17 to 28, which emits white light by virtue of the fact that the semiconductor body emits blue radiation and the luminescent material converts blue radiation into green and into red radiation.

32. Light-emitting semiconductor component according to Claim 31, in which the emission spectrum has a respective maximum at approximately 430 nm, at approximately 500 nm and at approximately 615 nm.

33. Light-emitting semiconductor component according to one of Claims 17 to 32, in which light-scattering particles are additionally added to the casting compound.

34. Light-emitting semiconductor component according to Claim 28, in which light-scattering particles are added to the transparent encapsulation (10).

35. Light-emitting semiconductor component according to one of Claims 17 to 34, in which the semiconductor body emits, apart from a visible radiation, ultraviolet radiation that is converted into visible radiation by the casting compound.

36. Semiconductor body (1) having a semiconductor layer sequence (7) that is suitable for emitting electromagnetic radiation from the ultraviolet, blue and/or green spectral range during operation of the semiconductor component, on which a layer (4) composed of a casting compound according to one of Patent Claims 1 to 6 is applied.

37. Semiconductor body according to Claim 36, which is produced on the basis of GaₓAl₁₋ₓN or on the basis of GaₓIn₁₋ₓN.

## Revendications

1. Pâte de coulée (5) à conversion de longueur d'onde, à base d'une résine époxy transparente de coulée, pour un composant électroluminescent qui présente un corps (1) qui émet de la lumière ultraviolette, bleue ou verte et dans laquelle est dispersée une poudre de pigment de substance inorganique luminescente qui présente des pigments (6) de substances luminescentes de l'ensemble des grenats dopés aux terres rares, des thiogallates dopés aux terres rares, des aluminates dopés aux terres rares et/ou des orthosilicates dopés aux terres rares, les pigments de substances luminescentes se présentant en grains d'une taille ≤ 20 µm avec un d₅₀ ≤ 5 µm.

2. Pâte de coulée selon la revendication 1, dans laquelle des pigments (6) de substances luminescentes ont la forme de billes ou d'écailles.

3. Pâte de coulée selon la revendication 1 ou 2, dans laquelle le diamètre moyen d₅₀ des grains de pigments (6) de substances luminescentes est compris entre 1 et 2 µm.

4. Pâte de coulée selon l'une des revendications 1 à 3, a la composition suivante :
a) résine époxy de coulée ≥ 60 % en poids
b) pigments de substances luminescentes > 0 et ≤ 25 % en poids
c) agent thixotropique > 0 et ≤ 10 % en poids
d) diffuseur minéral > 0 et ≤ 10 % en poids
e) adjuvants de traitement > 0 et ≤ 3 % en poids
f) agents d'hydrophobisation > 0 et ≤ 3 % en poids
g) agent de renforcement de l'adhérence > 0 et ≤ 2 % en poids.

5. Pâte de coulée selon l'une des revendications 1 à 4, dont la teneur en fer est ≤ 20 ppm.

6. Pâte de coulée selon l'une des revendications 1 à 5, dans laquelle les pigments (6) de substances luminescentes sont dotés d'un revêtement de silicone.

7. Procédé de préparation d'une pâte de coulée à base d'une résine époxy transparente de coulée, pour un composant électroluminescent qui présente un corps (1) émettant de la lumière ultraviolette, bleue ou verte, et dans lequel une poudre de pigments de substances inorganiques luminescentes présentant des pigments (6) de substances luminescentes de l'ensemble des grenats dopés aux terres rares, des thiogallates dopés aux terres rares, des aluminates dopés aux terres rares et/ou des orthosilicates dopés aux terres rares, en grains d'une taille ≤ 20 µm dont le d₅₀ est ≤ 5 µm, est préparée et est dispersée dans la pâte de coulée.

8. Procédé selon la revendication 7, dans lequel la poudre de pigments de substances luminescentes est traitée thermiquement à une température ≥ 200°C.

9. Procédé selon la revendication 7 ou 8, dans lequel la poudre de pigments de substances luminescentes est mise en suspension dans un alcool à haut point d'ébullition et est ensuite séchée.

10. Procédé selon l'une des revendications 7 à 9, dans lequel une cire d'hydrophobisation au silicone est ajoutée à la poudre de pigments de substances luminescentes.

11. Procédé selon l'une des revendications 7 à 10, dans lequel la surface de la poudre de pigments de substances luminescentes est modifiée à haute température avec des alcools, des glycoléthers et des silicones.

12. Procédé selon l'une des revendications 7 à 11, dans lequel une poudre de pigments de substances luminescentes dont le diamètre moyen des grains d₅₀ est compris entre 1 et 2 µm est préparée.

13. Procédé selon l'une des revendications 7 à 12, dans lequel on mélange
a) une résine époxy de coulée à ≥ 60 % en poids
b) des pigments de substances luminescentes entre > 0 et ≤ 25 % en poids
c) un agent thixotropique entre > 0 et ≤ 10 % en poids
d) un diffuseur minéral entre > 0 et ≤ 10 % en poids
e) des adjuvants de traitement entre > 0 et ≤ 3 % en poids
f) des agents d'hydrophobisation entre > 0 et ≤ 3 % en poids
g) un agent de renforcement de l'adhérence entre > 0 et ≤ 2 % en poids.

14. Procédé selon l'une des revendications 7 à 13, dans lequel les pigments (6) de substances luminescentes sont dotés d'un revêtement de silicone.

15. Procédé de fabrication d'un composant semi-conducteur émettant de la lumière, dans lequel un corps semi-conducteur (1) qui présente une succession (7) de couches semi-conductrices qui convient pour émettre un rayonnement électromagnétique dans la plage spectrale de l'ultraviolet, du bleu et/ou du vert lorsque le composant semi-conducteur est utilisé, est englobé au moins en partie dans une pâte de coulée selon l'une des revendications 1 à 6.

16. Procédé de fabrication d'un composant semi-conducteur émettant de la lumière, dans lequel une couche (4) d'une pâte de coulée selon l'une des revendications 1 à 6 est appliquée sur un corps semi-conducteur (1) qui présente une succession (7) de couches semi-conductrices qui convient pour émettre un rayonnement électromagnétique dans la plage spectrale de l'ultraviolet, du bleu et/ou du vert lorsque le composant semi-conducteur est utilisé et le corps semi-conducteur (1) est monté dans un boîtier SMD ou un boîtier radial.

17. Composant semi-conducteur émettant de la lumière, fabriqué à l'aide d'une pâte de coulée à conversion de longueur d'onde selon l'une des revendications 1 à 6, et présentant un corps semi-conducteur (1) qui présente une succession (7) de couches semi-conductrices qui convient pour émettre un rayonnement électromagnétique dans la plage spectrale de l'ultraviolet, du bleu et/ou du vert lorsque le composant semi-conducteur est en fonctionnement, les pigments de substances luminescentes convertissant une partie du rayonnement dans cette plage spectrale en un rayonnement de plus grande longueur d'onde, de telle sorte que le composant semi-conducteur émette un rayonnement mixte, en particulier une lumière de couleur mélangée constituée de ce rayonnement et d'un rayonnement dans la plage spectrale de l'ultraviolet, du bleu et/ou du vert.

18. Composant semi-conducteur émettant de la lumière selon la revendication 17, dans lequel la pâte de coulée englobe au moins une partie du corps semi-conducteur (1).

19. Composant semi-conducteur émettant de la lumière selon la revendication 17 ou 18, dans lequel le spectre du rayonnement émis par le corps semi-conducteur (1) présente un maximum d'intensité à une longueur d'onde inférieure ou égale à 520 nm et dans lequel la plage de longueurs d'onde absorbées de manière spectralement sélective par les pigments de substances luminescentes est située à l'extérieure de ce maximum d'intensité.

20. Composant semi-conducteur émettant de la lumière selon la revendication 17 ou 18, dans lequel le spectre du rayonnement émis par le corps semi-conducteur (1) présente un maximum d'intensité à une longueur d'onde comprise entre 420 nm et 460 nm.

21. Composant semi-conducteur émettant de la lumière selon la revendication 17 ou 18, dans lequel le spectre du rayonnement émis par le corps semi-conducteur (1) présente des maximums d'intensité à 430 nm ou à 450 nm.

22. Composant semi-conducteur émettant de la lumière selon la revendication 19, 20 ou 21, dans lequel le corps semi-conducteur est fabriqué à base de GaₓAl₁₋ₓN ou à base de GaₓIn₁₋ₓN .

23. Composant semi-conducteur émettant de la lumière selon l'une des revendications 17 à 22, dans lequel plusieurs types différents de particules de substances luminescentes qui émettent à différentes longueurs d'onde sont dispersées dans la pâte de coulée (5).

24. Composant semi-conducteur émettant de la lumière selon l'une des revendications 17 à 22, dans lequel la pâte de coulée (5) est dotée de pigments (6) de substances luminescentes qui diffèrent en termes de réseau hôte, de nature et d'ampleur du dopage.

25. Composant semi-conducteur émettant de la lumière selon l'une des revendications 17 à 24, dans lequel le corps semi-conducteur (1) est disposé dans une découpe (9) ménagée dans un boîtier de base (8) et en ce qu'au moins une partie de la découpe (9) est remplie de la pâte de coulée (5).

26. Composant semi-conducteur émettant de la lumière selon l'une des revendications 17 à 24, dans lequel le corps semi-conducteur (1) est fixé dans une partie (16), servant de réflecteur, d'une borne électrique (2) dont au moins une partie est remplie de la pâte de coulée (5).

27. Composant semi-conducteur émettant de la lumière selon l'une des revendications 17 à 24, dans lequel une couche (4) de pâte de coulée est appliquée sur le corps semi-conducteur (1).

28. Composant semi-conducteur émettant de la lumière selon l'une des revendications 25 à 27, dans lequel les surfaces libres du corps semi-conducteur (1) sont recouvertes par la pâte de coulée (5) sur laquelle une autre enveloppe transparente (10) est en outre appliquée.

29. Composant semi-conducteur émettant de la lumière selon l'une des revendications 17 à 28, qui émet de la lumière blanche par le fait que le corps semi-conducteur émet un rayonnement bleu et que la substance luminescente convertit le rayonnement bleu en rayonnement jaune.

30. Composant semi-conducteur émettant de la lumière selon la revendication 29, dans lequel le spectre d'émission présente des maximums entre environ 400 et environ 430 nm et entre environ 550 et environ 580 nm.

31. Composant semi-conducteur émettant de la lumière selon l'une des revendications 17 à 28, qui émet de la lumière blanche par le fait que le corps semi-conducteur émet un rayonnement bleu et que la substance luminescente convertit le rayonnement bleu en rayonnement vert et en rayonnement rouge.

32. Composant semi-conducteur émettant de la lumière selon la revendication 31, dans lequel le spectre d'émission présente des maximums à environ 430 nm, à environ 500 nm et à environ 615 nm.

33. Composant semi-conducteur émettant de la lumière selon l'une des revendications 17 à 32, dans lequel des particules diffusant la lumière sont en outre ajoutées à la pâte de coulée.

34. Composant semi-conducteur émettant de la lumière selon la revendication 28, dans lequel des particules diffusant la lumière sont ajoutées à l'enveloppe transparente (10).

35. Composant semi-conducteur émettant de la lumière selon l'une des revendications 17 à 34, dans lequel le composant semi-conducteur émet en plus d'un rayonnement visible un rayonnement ultraviolet qui est converti en rayonnement visible par la pâte de coulée.

36. Corps semi-conducteur (1) qui présente une succession (7) de couches semi-conductrices qui convient pour émettre un rayonnement électromagnétique dans la plage spectrale de l'ultraviolet, du bleu et/ou du vert lorsque le composant semi-conducteur est en fonctionnement et sur lequel une couche (4) de pâte de coulée selon l'une des revendications 1 à 6 est appliquée.

37. Corps semi-conducteur selon la revendication 36, fabriqué à base de GaₓAl₁₋ₓN ou à base de GaₓIn₁₋ₓN.
